# EUROPEAN PATENT APPLICATION

(11) **EP 4 832 706 A1**
(43) Date of publication of application: **28.10.2026**
(21) Application number: 25745385.2
(22) Date of filing: 24.01.2025
(51) Int. Cl.: H10H 29/85, H10H 29/24, H10H 20/82, H10H 20/831, H10H 20/84, H10H 29/80

(54) **LIGHT-EMITTING DEVICE**

(30) Priority: 26.01.2024 US 202463625514 P; 29.01.2024 US 202463626218 P; 02.02.2024 US 202463548969 P; 23.01.2025 US 202519034994
(71) Applicant: Seoul Viosys Co., Ltd., Ansan-si, Gyeonggi-do 15429 (KR)
(72) Inventor: LEE, Chung Hoon, Ansan-si Gyeonggi-do 15429 (KR); CHA, Nam Goo, Ansan-si Gyeonggi-do 15429 (KR)
(74) Representative: Isarpatent
(86) International application number: PCT/KR2025/001459
(87) International publication number: WO 2025/159563

(57) **Abstract**

According to an aspect of the present disclosure, there may be provided a light emitting device, including: a substrate; a plurality of light emitters disposed on an upper surface of the substrate to emit light; a first electrode disposed between the substrate and the plurality of light emitters and electrically connected to the plurality of light emitters; and a second electrode spaced apart from the substrate and electrically connected to the plurality of light emitters, wherein the first electrode and the second electrode are spaced apart from each other in an up and down direction by at least one of the plurality of light emitters, and extend while intersecting in the at least one light emitter when viewed from above.

## Description

### TECHNICAL FIELD

The present disclosure relates to a light emitting device

### BACKGROUND ART

Recently, a light emitting diode (LED) is widely used in a light emitting device. The light emitting diode converts electric signals into light forms, such as infrared, visible light, and ultraviolet light, by using characteristics of compound semiconductors.

As light efficiency of the light emitting diode increases, a light emitter is being applied to various fields including a display device, a lighting device, a vehicle lamp, a ship, etc.

### DISCLOSURE OF INVENTION

### TECHNICAL PROBLEM

The embodiments of the present invention have been devised in the context of the background described above, and are directed to providing a light emitting device including a plurality of light emitters that can operate individually to emit light.

### TECHNICAL SOLUTION

In accordance with one aspect of the present disclosure, there may be provided a light emitting device, including: a substrate; a plurality of light emitters disposed on an upper surface of the substrate to emit light; a first electrode disposed between the substrate and the plurality of light emitters and electrically connected to the plurality of light emitters; and a second electrode spaced apart from the substrate and electrically connected to the plurality of light emitters, wherein the first electrode and the second electrode are spaced apart from each other in an up and down direction by at least one of the plurality of light emitters, and extend while intersecting in the at least one light emitter when viewed from above.

Further, there may be provided the light emitting device in which an intersection where the first electrode and the second electrode intersect is formed in a rectangular or a rhombus shape.

Further, there may be provided the light emitting device in which the first electrode extends in one direction and is connected to the plurality of light emitters, the second electrode extends in the other direction different from the one direction and is connected to the plurality of light emitters, a length of the first electrode perpendicular to the one direction is 70% or less of a length of the one light emitter perpendicular to the one direction, and a length of the second electrode in a direction perpendicular to the other direction is 70% or less of a length of the at least one light emitter in the direction perpendicular to the other direction.

Further, there may be provided the light emitting device in which an area of an upper surface of the at least one light emitter is 60% or more of an area of the first electrode projected toward the at least one light emitter.

Further, there may be provided the light emitting device in which the first electrode and the second electrode are formed in plural, each of the plurality of light emitters includes: a first conductive semiconductor layer connected to the first electrode; an active layer stacked on the first conductive semiconductor layer; and a second conductive semiconductor layer connected to the second electrode, and the active layer is disposed above a center of the light emitter.

Further, there may be provided the light emitting device in which each of the plurality of light emitters further includes an insulating layer that covers the first conductive semiconductor layer, the active layer, and the second conductive semiconductor layer, the insulating layer is formed with an insulating layer opening, and the plurality of second electrodes are electrically connected to the first conductive semiconductor layer, the active layer, or the second conductive semiconductor layer through the insulating layer opening.

Further, there may be provided the light emitting device in which when viewed from above, an edge of the insulating layer opening is disposed inward from an edge of the second electrode.

Further, there may be provided the light emitting device in which the second electrode is electrically connected to one of the plurality of light emitters and a light emitter adjacent to the one light emitter, and a virtual line connecting a center of the insulating layer opening of the one light emitter and a center of the insulating layer opening of the adjacent light emitter is disposed to be misaligned from a side surface of the second electrode.

Further, there may be provided the light emitting device in which unevenness is formed on a lower surface of the plurality of light emitters.

Further, there may be provided the light emitting device in which the second electrode is bent downward so as to be disposed below an upper end portion of the plurality of light emitters between the plurality of light emitters.

Further, there may be provided a light emitting device, including: a substrate; a plurality of first light emitters disposed on the substrate; a plurality of second light emitters disposed above the plurality of first light emitters; a plurality of third light emitters disposed above the plurality of second light emitters; a plurality of first electrodes disposed between the plurality of first light emitters and the substrate and electrically connected to the plurality of light emitters; a plurality of second electrodes disposed between the plurality of first light emitters and the plurality of second light emitters and electrically connected to the plurality of second light emitters; a plurality of third electrodes disposed between the plurality of second light emitters and the plurality of third light emitters and electrically connected to the plurality of light emitters; and a plurality of common electrodes electrically connected to the plurality of first light emitters, the plurality of second light emitters, and the plurality of third light emitters.

Further, there may be provided the light emitting device in which the plurality of first electrodes are disposed to intersect the plurality of second electrodes or the plurality of third electrodes when viewed from above.

Further, there may be provided the light emitting device in which the plurality of first electrodes are disposed to extend in one direction and be spaced apart from each other in the other direction different from the one direction, and are connected to some of the plurality of first light emitters, the plurality of second electrodes are spaced apart from each other in the one direction and extend in the other direction, and are connected to some of the plurality of second light emitters, and the plurality of third electrodes are disposed to extend in the other direction and be spaced apart from each other in the one direction.

Further, there may be provided the light emitting device in which the plurality of first electrodes are disposed to extend in the one direction and be spaced apart from each other in the other direction or extend in the other direction and be spaced apart from each other in the one direction, and are connected to some of the plurality of first light emitters.

Further, there may be provided the light emitting device in which each of the plurality of common electrodes includes: a first common electrode disposed on the substrate and extending in the one direction; and a plurality of second common electrodes extending upward from the first common electrode and connected to one of the plurality of first light emitters, one of the plurality of second light emitters, and one of the plurality of third light emitters.

Further, there may be provided the light emitting device in which some of the plurality of first light emitters are arranged in the one direction and connected to one of the plurality of first electrodes, some of the plurality of second light emitters are arranged in the one direction and connected to different second electrodes among the plurality of second electrodes, and some of the plurality of third light emitters are arranged in the one direction and connected to different third electrodes among the plurality of third electrodes.

Further, there may be provided the light emitting device in which another portion of the plurality of first light emitters are arranged in the other direction and connected to different first electrodes among the plurality of first electrodes, another portion of the plurality of other second light emitters are arranged in the other direction and connected to one of the plurality of second electrodes, and some of the plurality of other third light emitters are arranged in the other direction and connected to one of the plurality of third electrodes.

Further, there may be provided the light emitting device further including: a first cover layer covering the plurality of first light emitters and the plurality of first electrodes; a second cover layer disposed above the first cover layer and covering the plurality of second light emitters and the plurality of second electrodes; and a third cover layer disposed above the second cover layer and covering the plurality of third light emitters and the plurality of third electrodes, wherein a portion of the first cover layer is disposed between the plurality of first light emitters and the plurality of second electrodes, and a portion of the second cover layer is disposed between the plurality of second light emitters and the plurality of third electrodes.

Further, there may be provided a light emitting device including: a substrate; a plurality of light emitters disposed on an upper surface of the substrate to emit light; a plurality of first electrodes disposed between the substrate and the plurality of light emitters, extending in one direction, spaced apart from each other in the other direction different from the one direction, and electrically connected to the plurality of light emitters; a plurality of second electrodes spaced apart from the substrate, extending in the other direction, spaced apart from each other in the one direction and electrically connected to the plurality of light emitters; and a cover layer covering the plurality of light emitters, the plurality of first electrodes, and the plurality of second electrodes.

Further, there may be provided the light emitting device, further including: an outer layer stacked on the cover layer.

### EFFECT OF INVENTION

According to one embodiment of the present disclosure, there is an effect in that a plurality of light-emitting elements can be driven independently.

In addition, according to one embodiment of the present disclosure, it is possible to minimize the defect factors of the light emitter and improve the light efficiency.

In addition, according to one embodiment of the present disclosure, since light may be prevented from being absorbed inside the second conductive semiconductor layer, it is possible to improve the light extraction efficiency.

In addition, according to one embodiment of the present disclosure, it is possible to protect the light emitter from the external environment by the insulating layer.

In addition, according to one embodiment of the present disclosure, since light may be diffused by unevenness, it is possible to increase the light extraction efficiency of the light emitter.

In addition, according to one embodiment of the present disclosure, since the plurality of light emitters, the plurality of first electrodes, and the plurality of second electrodes may be protected by the cover layer, it is possible to improve the reliability of the light emitting device.

In addition, according to one embodiment of the present disclosure, it is possible to prevent the plurality of light emitters, the plurality of first electrodes, and the plurality of second electrodes from being detached or peeled off from the light emitting device 1 by the cover layer.

### BRIEF DESCRIPTION OF THE DRAWINGS

FIG. 1 is a perspective view of a light emitting device according to a first embodiment of the present disclosure.
FIG. 2 is a plan view of the light emitting device of FIG. 1 when viewed from above.
FIG. 3 is a cross-sectional view taken along line A-A' of FIG. 2.
FIG. 4 is a cross-sectional view taken along line B-B' of FIG. 2.
FIG. 5 is a diagram illustrating a color coordinate region of light of the light emitting device of FIG. 1.
FIG. 6 is a diagram illustrating an appearance in which an imaginary line connecting centers of insulating layer openings of light emitters disposed adjacent to each other among the plurality of light emitters of the light emitting device of FIG. 1 and an extension direction of a second electrode are disposed in a misaligned manner.
FIG. 7 is a diagram illustrating an appearance in which an intersection between a second electrode and a first electrode of the light emitting device of FIG. 1 is a square shape.
FIG. 8 is a diagram illustrating an appearance in which the intersection between the second electrode and the first electrode of the light emitting device of FIG. 1 is a diamond shape.
FIG. 9 is a diagram illustrating an appearance in which the first electrode of the light emitting device of FIG. 1 is projected onto the light emitter and a projected area is formed.
FIG. 10 is a diagram illustrating an appearance in which the second electrode of the light emitting device of FIG. 1 is projected onto the light emitter and a projected area is formed.
FIG. 11 is a diagram illustrating an appearance in which the second electrode of the light emitting device of FIG. 1 is bent downward.
FIG. 12 is a diagram illustrating an appearance in which the second electrode of the light emitting device of FIG. 1 is connected to the light emitter by passing through a cover layer opening.
FIG. 13 is a cross-sectional view of a light emitting device according to a second embodiment of the present disclosure.
FIG. 14 is a perspective view of a light emitting device according to a third embodiment of the present disclosure.
FIG. 15 is a cross-sectional view of the light emitting device of FIG. 14.
FIG. 16 is a perspective view of a light emitting device according to a fourth embodiment of the present disclosure.
FIG. 17 is a perspective view of a light emitting device according to a fifth embodiment of the present disclosure.

### BSST MODE FOR IMPLEMENTIGN THE INVENTION

Hereinafter, specific embodiments for implementing a spirit of the present disclosure will be described in detail with reference to the drawings.

In describing the present disclosure, detailed descriptions of known configurations or functions may be omitted to clarify the present disclosure.

When an element is referred to as being 'connected' to, 'supported' by, or 'supplied' to another element, it should be understood that the element may be directly connected to, supported by, or supplied to another element, but that other elements may exist in the middle.

The terms used in the present disclosure are only used for describing specific embodiments, and are not intended to limit the present disclosure. Singular expressions include plural expressions unless the context clearly indicates otherwise.

Further, in the present disclosure, it is to be noted that expressions, such as an upper, a side, an upper side, a lower side, and an up and down direction, are described based on the illustration of drawings, but may be modified if directions of corresponding objects are changed. For the same reasons, some components are exaggerated, omitted, or schematically illustrated in the accompanying drawings, and the size of each component does not fully reflect the actual size.

Terms including ordinal numbers, such as first and second, may be used for describing various elements, but the corresponding elements are not limited by these terms. These terms are only used for the purpose of distinguishing one element from another element.

In the present specification, it is to be understood that the terms such as "including" are intended to indicate the existence of the certain features, areas, integers, steps, actions, elements, combinations, and/or groups thereof disclosed in the specification, and are not intended to preclude the possibility that one or more other certain features, areas, integers, steps, actions, elements, combinations, and/or groups thereof may exist or may be added.

Hereinafter, a light emitting device 1 according to a first embodiment of the present disclosure will be described.

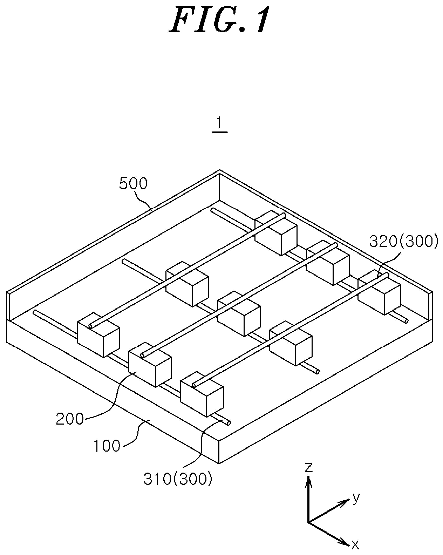

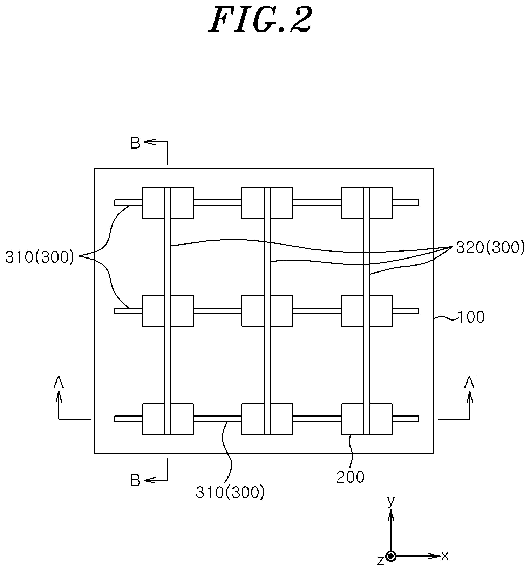

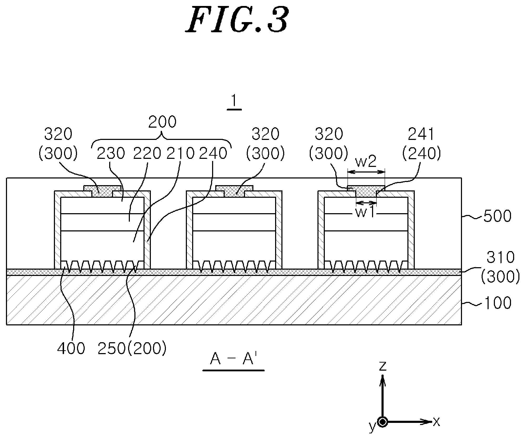

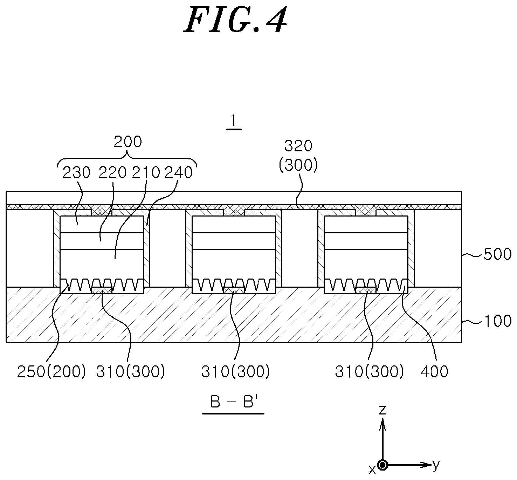

Referring to FIGS. 1 to 4, the light emitting device 1 according to the first embodiment of the present disclosure may receive power from the outside to emit light. The light emitting device 1 may display characters, symbols, images, videos, etc. In addition, the light emitting device 1 may be mounted on a vehicle. In other words, the light emitting device 1 may be included in a tail light, a headlight, a rear lamp, a tail lamp, an interior light, etc. In addition, the light emitting device 1 may be a high-quality display device with a clear contrast ratio and a clear contrast by reducing optical interference between a plurality of light emitters 200 (light emitters) and minimizing interference between driving regions. In addition, the light emitting device 1 may be applied to UV, blue light elements, IR elements, cyan (autonomous driving laser), etc. The light emitting device 1 may include a substrate 100, the plurality of light emitters 200, a plurality of electrodes 300, an adhesive layer 400, and a cover layer 500.

The plurality of light emitters 200, the plurality of electrodes 300, the adhesive layer 400, and the cover layer 500 may be disposed on the substrate 100. For example, the substrate 100 may be a printed circuit board (PCB) substrate on which an electric circuit is printed. In addition, the substrate 100 may be a thin-film transistor (TFT) backplane. The substrate 100 may include an alloy composed of one or more or some of Cu, Zn, Au, Ni, Al, Mg, Cd, Be, W, Mo, Si, Ag, and Fe having electrical conductivity, thereby increasing conductivity of heat and electricity. However, this is only an example, and the substrate 100 may include one or more insulating materials such as FR1, CEM-1, FR-4, PMMA, PCT, and PPA, thereby preventing a short circuit between the respective circuits. Here, FR1 is a material in which copper foil and laminated paper are stacked, and CEM-1 is a material in which copper foil, glass fiber fabric, laminated paper, and glass fiber fabric are sequentially stacked. In addition, FR-4 is a material in which copper foil and glass fiber fabric or glass fiber fabric is stacked. In addition, the substrate 100 may include ceramics such as alumina (Al2O3), aluminum nitride (AlN), and zirconia toughened alumina (ZTA).

The substrate 100 may be a flexible substrate that may freely form a curved shape. The substrate 100 may include a light-transmitting material that may transmit light emitted from the plurality of light emitters 200. In addition, the substrate 100 may include a light guide structure capable of guiding the light emitted from the plurality of light emitters 200, but is not limited thereto and may be implemented with various materials and shapes.

The plurality of light emitters 200 may emit light. The plurality of light emitters 200 may be electrically connected to an electric circuit of the substrate 100 and may receive electricity from the outside through the electric circuit to emit light. Each of the plurality of light emitters 200 may be disposed adjacent to each other to emit light. For example, each of the plurality of light emitters 200 may be disposed in N rows and M columns to emit light. In other words, each of the plurality of light emitters 200 may be arranged in N×M matrices to emit light. The number N of rows and the number M of columns of the plurality of light emitters 200 may be the same or different. In addition, the plurality of light emitters 200 may be driven individually. A driving voltage of the plurality of light emitters 200 may be 3 V or less. Therefore, it is possible to prevent the materials constituting the light emitting device 1 from being deformed due to heat generation. Any one of the plurality of light emitters 200 may have an EQE value of 80% or more at 10 mA/100 µm2. In addition, any one of the plurality of light emitters 200 may have a profile in which luminous intensity increases in the range of 0 to 10 mA.

The plurality of light emitters 200 may emit light of different colors. Alternatively, a difference in peak wavelengths of light emitted from the plurality of light emitters 200 may be 5 nm or less. The plurality of light emitters 200 may also emit light of the same color. Each of the plurality of light emitters 200 may emit blue, green, red, white light, UV light, etc. For example, at least one of the plurality of light emitters may emit light having a peak wavelength in a blue region, light having a peak wavelength in a green region, or light having a peak wavelength in a red region. In addition, the light emitter 200 may emit light having a peak wavelength in a cyan region.

In addition, the plurality of light emitters 200 may emit light having a peak wavelength in regions other than visible light. The plurality of light emitters 200 may be UVA, UVB, or UVC element having a peak wavelength in an ultraviolet region. In addition, the light emitter 200 may be an IR element. When the light emitter 200 is an ultraviolet light emitter having a peak wavelength in the ultraviolet region, a mounting ratio of the light emitter 200 may be improved and the amount of light may be improved, thereby increasing curing or sterilization efficiency.

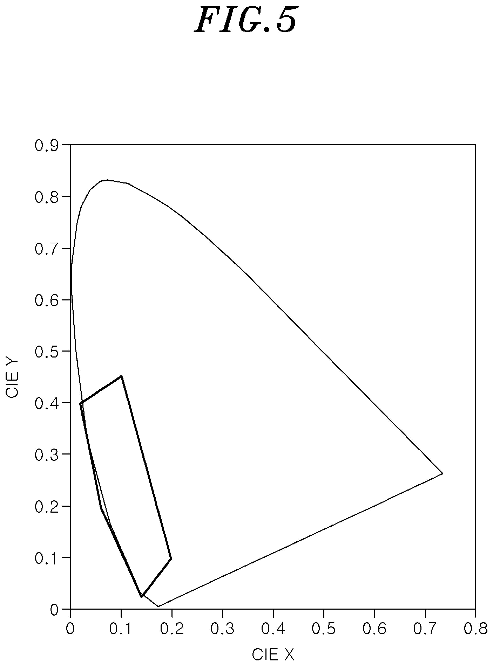

Referring back to FIG. 5, when the light emitter 200 emits light having a center wavelength in the cyan region, color coordinate regions (X, Y) of the light emitted from the light emitter 200 may be formed within a region where each coordinate of (0.14, 0.025), (0.06, 0.2), (0.02, 0.4), (0.1, 0.45), (0.2, 0.1), and (0.14, 0.025) is linearly connected. When the light emitter 200 emits light having the peak wavelength in the cyan region, the light emitting device 1 may be applied to a vehicle such as an electric vehicle.

A horizontal or vertical length of the plurality of light emitters 200 may be 50 µm or less. Specifically, the horizontal or vertical length of the light emitter 200 may be 20 µm. When a horizontal or vertical size of the light emitter 200 is 50 µm or less, the number of light emitters that may be mounted relative to an area of the substrate 100 may increase. When the horizontal or vertical size of the light emitter 200 is 50 µm or less, defect factors of the light emitters produced from one wafer may be reduced. When the horizontal or vertical size of the light emitter 200 is 50 µm or less, the defect factors of the light emitter 200 may be minimized, thereby improving the purity of the light emitter 200, improving the light efficiency, reducing defects at a high current, and improving the reliability of the light emitter 200.

Each of the plurality of light emitters 200 may include a first conductive semiconductor layer 210, an active layer 220, a second conductive semiconductor layer 230, and an insulating layer 240.

The first conductive semiconductor layer 210 is a semiconductor layer having a polarity opposite to that of the second conductive semiconductor layer 230. The first conductive semiconductor layer 210 may include an n-type impurity (e.g., Si, Ge, Sn). In this case, the first conductive semiconductor layer 210 may be an n-type semiconductor layer. However, this is merely an example, and the first conductive semiconductor layer 210 may also include a p-type impurity.

The active layer 220 may be stacked on the first conductive semiconductor layer 210. In other words, the active layer 220 may be located between the first conductive semiconductor layer 210 and the second conductive semiconductor layer 230. In addition, the active layer 220 may be disposed to be biased toward one side with respect to a center of a thickness of the light emitter 200. By the active layer 220, a vertical length of the first conductive semiconductor layer 210 may be formed to be greater than that of the second conductive semiconductor layer 230.

The second conductive semiconductor layer 230 may be stacked on the active layer 220. The second conductive semiconductor layer 230 may include a p-type impurity (for example, Mg, Sr, Ba). In this case, the second conductive semiconductor layer 230 may be a p-type semiconductor layer. However, this is merely an example, and the second conductive semiconductor layer 230 may also include an n-type impurity. Light emitted from the active layer 220 may pass through the second conductive semiconductor layer 230 and be emitted to the outside.

A vertical length of the second conductive semiconductor layer 230 may be formed to be less than that of the first conductive semiconductor layer 210. By the second conductive semiconductor layer 230, light may be prevented from being absorbed inside the second conductive semiconductor layer 230, thereby improving the light extraction efficiency. In addition, by the second conductive semiconductor layer 230, the length from the active layer 220 to an upper surface of the cover layer 500 may be formed short, thereby improving the light extraction efficiency of the light emitter 200 and increasing sharpness.

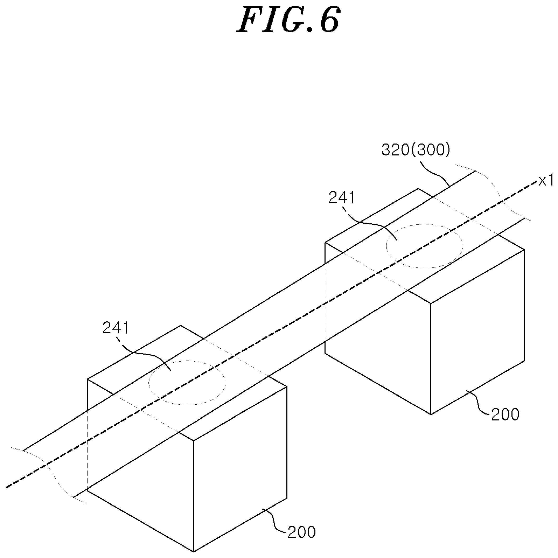

The insulating layer 240 may cover an outer surface of the first conductive semiconductor layer 210, the active layer 220, and the second conductive semiconductor layer 230. The insulating layer 240 may protect the light emitter 200 from the external environment. The insulating layer 240 may protect the light emitter 200 from moisture or physical pressure, thereby improving the reliability of the light emitter 200. An insulating layer opening 241 may be formed in the insulating layer 240. By the insulating layer opening 241, a plurality of second electrodes 320 may be electrically connected to the first conductive semiconductor layer 210, the active layer 220, or the second conductive semiconductor layer 230. The insulating layer opening 241 may extend in another direction or may have a circular shape. A length (width) w1 of the insulating layer opening 241 in one direction may be formed to be smaller than a length (width) w2 of the second electrode 320 in one direction. Even if the arrangement of the plurality of light emitters 200 is misaligned or the position of the insulating layer opening 241 is misaligned by the length of the insulating layer opening 241, the plurality of light emitters 200 and the second electrode 320 may be stably electrically connected. Referring back to FIG. 6, an imaginary line x1 connecting centers of the insulating layer openings 241 disposed in each of at least two adjacent light emitters 200 may not be parallel to a side surface of the second electrode 320. In other words, the imaginary line x1 and the side surface of the second electrode 320 may be disposed to be misaligned.

In addition, unevenness 250 may be formed on a lower surface of the plurality of light emitters 200. For example, the unevenness 250 may be a pattern that protrudes in an irregular shape from the lower surface of the light emitter 200 toward the substrate 100. In another example, the unevenness 250 may be a pattern that protrudes in an irregular shape from a surface of the first conductive semiconductor layer 210 toward the active layer 220. The unevenness 250 may include two or more layers having different doping concentrations. The unevenness 250 may have a region including different materials. The unevenness 250 may include a region where a curved portion and a straight portion intersect each other. By the unevenness 250, the light emitted from the active layer 220 of the light emitter 200 may be diffused, thereby improving the light extraction efficiency of the light emitter 200. In addition, the unevenness 250 may improve the light extraction efficiency of light reflected by the adhesive layer 400.

In addition, the light emitter 200 may be formed in a structure in which a horizontal length changes as it goes in an up and down direction. For example, the light emitter 200 may be formed so that a horizontal length of its upper side is longer than that of its lower side. In other words, a horizontal length of the second conductive semiconductor layer 230 may be longer than that of the first conductive semiconductor layer 210. A side surface of the light emitter 200 may be formed as an inclined surface to form an obtuse angle with an upper surface of the light emitter 200 or a lower surface of the light emitter 200. When the side surface of the light emitter 200 is formed as an inclined surface, the phenomenon in which a current is concentrated at corners of the light emitter 200 may be reduced.

The plurality of electrodes 300 may be electrically connected to the plurality of light emitters 200 so that light is emitted from the plurality of light emitters 200. The plurality of electrodes 300 may be a circuit pattern that supplies electricity to the plurality of light emitters 200. The plurality of electrodes 300 may include various circuit elements that supply electricity. In addition, the plurality of electrodes 300 may include a conductive material. The plurality of electrodes 300 may be a transparent electrode. For example, the electrode 300 may include metal, Al, Ni, Ti, Cr, ITO, ZnO, IZO, etc. The plurality of electrodes 300 may include a first electrode 310 and a second electrode 320.

The first electrode 310 may be formed in plural and may be electrically connected to the plurality of light emitters 200. The plurality of first electrodes 310 may be disposed between the substrate 100 and the plurality of light emitters 200. The plurality of first electrodes 310 may be electrically connected to the first conductive semiconductor layers 210 of the plurality of light emitters 200.

The plurality of first electrodes 310 may be disposed to extend so as to intersect the plurality of second electrodes 320 when viewed from above. For example, the plurality of first electrodes 310 and the plurality of second electrodes 320 may be disposed to be perpendicular to each other or to be misaligned from each other so as to be formed at a predetermined angle when viewed from above. However, the present disclosure is not limited thereto, and the plurality of first electrodes 310 and the plurality of second electrodes 320 may extend in the same direction as each other. When viewed from above, the angle formed by the first electrodes 310 and the second electrodes 320 may be an acute angle. The plurality of first electrodes 310 and the plurality of second electrodes 320 may be spaced apart from each other in the and down direction while intersecting each other. Therefore, the first electrode 310 and the second electrode 320 may be disposed apart from each other to prevent a short circuit. In addition, when viewed from above, an area of the electrode overlapping the light emitter 200 may be minimized, so the absorption of light emitted from the light emitter (200) by the electrode may be minimized.

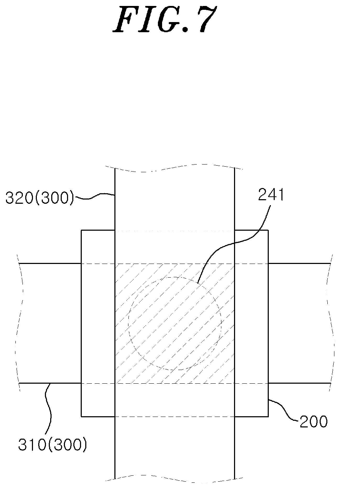

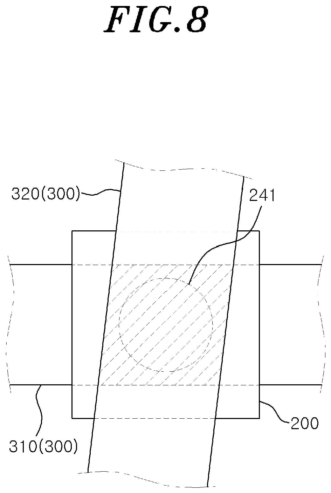

Referring back to FIG. 7, as an example, when viewed from above, the plurality of first electrodes 310 and the plurality of second electrodes 320 are arranged, and thus, the shape formed by the intersections between the first electrodes 310 and the second electrodes 320 may be a square. Referring back to FIG. 8, for another example, when viewed from above, the plurality of first electrodes 310 and the plurality of second electrodes 320 are arranged, and thus, the shape formed by the intersections between the first electrodes 310 and the second electrodes 320 may be a rhombus.

The plurality of first electrodes 310 may extend in one direction and be disposed to be spaced apart from each other in the other direction from one direction. The other direction may be a vertical direction, but is not limited thereto. For example, the plurality of first electrodes 310 may be formed in a plurality of columns or a plurality of rows on the substrate 100. Any one of the plurality of first electrodes 310 may be connected to some of the plurality of light emitters 200 arranged in one direction. Another one of the plurality of first electrodes 310 may be connected to some of the plurality of other light emitters 200 arranged in one direction. In addition, another one of the plurality of first electrodes 310 may be connected to some other of the plurality of light emitters 200 arranged in one direction. In other words, each of the first electrodes 310 may be connected to two or more light emitters 200.

The length (width) of each of the plurality of first electrodes 310 in the other direction may be formed smaller than the length of the light emitter 200 in the other direction. For example, the length of each of the plurality of first electrodes 310 in the other direction may be 70% or less with respect to the length of the light emitter 200 in the other direction. Specifically, the length of each of the plurality of first electrodes 310 in the other direction may be 50% or less or 30% or less with respect to the length of the light emitter 200 in the other direction.

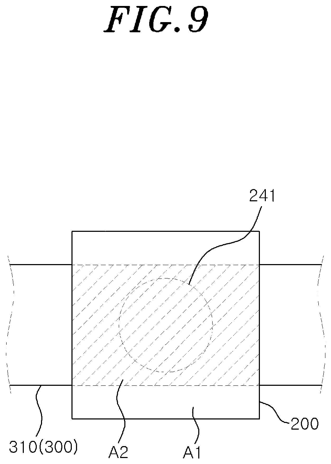

Referring back to FIG. 9, when any one of the plurality of first electrodes 310 is projected toward any one of the plurality of light emitters 200, an area A1 of the upper surface of the light emitter 200 may be 60% or more relative to a projected area A2. Accordingly, a driving voltage of the light emitter 200 may be lowered while the light absorption by the first electrode 310 is minimized. A first region of the first conductive semiconductor layer 210 to which the first electrode 310 supplies current may be disposed inwardly, spaced apart from an outer periphery of the light emitter 200. The outer surface of the first conductive semiconductor layer 210 may be oxidized, damaged, or uneven, potentially providing a leakage path. The first region of the first conductive semiconductor layer 210, to which a current is supplied through the first electrode 310, may be disposed inwardly on an outer side surface of the light emitter 200 to prevent the current supplied to the light emitter 200 from flowing through the leakage path.

A thickness of the first electrode 310 may be thinner than that of the insulating layer 240. Therefore, the first electrode 310 may be prevented from being broken due to stress when passing over a step such as a side surface of the insulating layer opening 241 or when formed on unevenness.

The second electrode 320 may be formed in plural and may be electrically connected to the plurality of light emitters 200. The plurality of second electrodes 320 may be disposed spaced apart from the substrate 100 upwardly. In other words, the plurality of second electrodes 320 may be supported by the cover layer 500 and disposed on an upper side of the plurality of light emitters 200. The plurality of second electrodes 320 may be electrically connected to the second conductive semiconductor layers 230 of the plurality of light emitters 200.

The plurality of second electrodes 320 may be disposed to extend in the other direction and be spaced apart from each other in one direction. For example, the plurality of second electrodes 320 may be arranged in a plurality of columns or a plurality of rows. Any one of the plurality of second electrodes 320 may be connected to some of the plurality of light emitters 200 arranged in the other direction. Another one of the plurality of second electrodes 320 may be connected to some of the plurality of other light emitters 200 arranged in the other direction. In addition, another one of the plurality of second electrodes 320 may be connected to some other of the plurality of light emitters 200 arranged in one direction. In other words, each of the plurality of second electrodes 320 may be connected to two or more light emitters 200.

The length (width) of each of the plurality of second electrodes 320 in the one direction may be formed smaller than the length of the light emitter 200 in one direction. For example, the length of each of the plurality of second electrodes 320 in one direction may be 70% or less with respect to the length of the light emitter 200 in one direction. Specifically, the length of each of the plurality of second electrodes 320 in one direction may be 50% or less or 30% or less with respect to the length of the light emitter 200 in one direction.

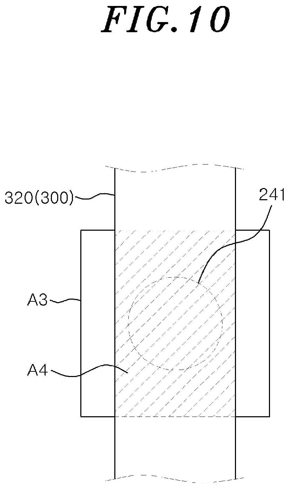

Referring back to FIG. 10, when any one of the plurality of second electrodes 320 is projected toward any one of the plurality of light emitters 200, an area A3 of the lower surface of the light emitter 200 may be 60% or more relative to a projected area A4. Specifically, when any one of the plurality of second electrodes 320 is projected toward any one of the plurality of light emitters 200, the projected area A4 may be 40% or less or 20% or less relative to the area A3 of the lower surface of the light emitter 200. By the thin area of the plurality of second electrodes 320, the light absorption by the second electrodes 320 may be minimized, thereby increasing the light extraction efficiency of the light emitter 200 and lowering the driving voltage of the light emitter 200. A second region of the second conductive semiconductor layer 230 to which the second electrode 320 supplies current may be disposed inwardly, spaced apart from the outer periphery of the light emitter 200. An outer side surface of the second conductive semiconductor layer 230 may be oxidized, damaged, or uneven, potentially providing a leakage path. The second region of the second conductive semiconductor layer 230, to which a current is supplied through the second electrode 320, may be disposed inwardly on the outer side surface of the light emitter 200 to prevent the current supplied to the light emitter 200 from flowing through the leakage path.

A thickness of the second electrode 320 may be thinner than that of the insulating layer 240. The second electrode 320 may be prevented from being broken due to stress when it passes over a step such as a side surface of the insulating layer opening 241 or is formed on unevenness.

The adhesive layer 400 may make the plurality of light emitters 200 adhere to the substrate 100. The adhesive layer 400 may be disposed between the plurality of light emitters 200 and the substrate 100. In addition, the adhesive layer 400 may include a plurality of conductive materials. The adhesive layer 400 may reflect light emitted from the light emitters 200 with a predetermined reflectivity. The reflectivity of the adhesive layer 400 may be 50% or more. Specifically, the reflectivity of the adhesive layer 400 may be 70% or more. However, in another form, the adhesive layer 400 may be a light-transmitting material. The adhesive layer 400 may be omitted.

The cover layer 500 may be disposed on the substrate 100 to cover the plurality of light emitters 200 and the plurality of electrodes 300. In other words, the cover layer 500 may cover at least a portion of the side and upper surfaces of the plurality of light emitters 200. The cover layer 500 may be a light-transmitting layer or a transparent layer. In addition, the cover layer 500 may cover at least a portion of the plurality of first electrodes 310 and the plurality of second electrodes 320. An upper surface of the cover layer 500 may be formed flat, but is not limited thereto, and may have a curved region or an inclined region in at least one region. In addition, a pattern region in which a pattern is formed may be formed in at least one region of the cover layer 500.

In addition, the cover layer 500 may be disposed on the substrate 100 to press the plurality of light emitters 200, the plurality of first electrodes 310, and the plurality of second electrodes 320 toward the substrate 100. The cover layer 500 may also be called a material layer. The cover layer 500 may cover the plurality of light emitters 200, the plurality of first electrodes 310, and the plurality of second electrodes 320 to prevent the plurality of light emitters 200, the plurality of first electrodes 310, and the plurality of second electrodes 320 from being detached or peeled off from the light emitting device 1. In addition, the cover layer 500 may protect the plurality of light emitters 200, the plurality of first electrodes 310, and the plurality of second electrodes 320 that are mounted on the substrate 100, thereby improving the reliability of the light emitting device 1. In addition, the cover layer 500 may diffuse the light emitted from the plurality of light emitters 200. The cover layer 500 may improve the light extraction efficiency by guiding the light emitted from the plurality of light emitters 200.

In addition, the cover layer 500 may be a wavelength conversion layer. In other words, the cover layer 500 may include a wavelength converter. The wavelength converter may be excited by the light emitted from the plurality of light emitters 200 and emit light having a center wavelength different from a center wavelength of the light emitted from the light emitters 200. The wavelength converter may be excited by the light emitted from the plurality of light emitters 200 and emit light having a center wavelength longer than the center wavelength of the light emitted from the plurality of light emitters 200. Such wavelength converter may be formed in plural. The plurality of wavelength converters may be excited by the light from the plurality of light emitters 200 and emit light having different center wavelengths. Depending on the combination of the plurality of wavelength converters and the plurality of light emitters 200, the light emitting device 1 may also implement various colors that can be implemented within a blue region to a red region. In addition, the light emitting device 1 may implement white light of various color temperatures by a wavelength converter.

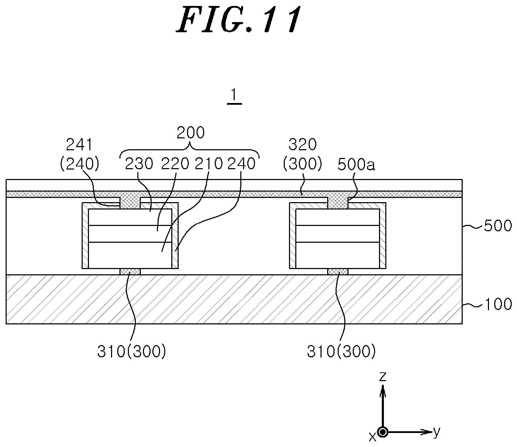

In addition, referring back to FIG. 11, the cover layer 500 may support the plurality of second electrodes 320. A cover layer opening 500a may be formed in the cover layer 500 so that the second electrode 320 is electrically connected to the light emitter 200. The cover layer opening 500a may be disposed between the second electrode 320 and the light emitter 200 to provide a passage through which the second electrode 320 passes. In addition, the cover layer opening 500a may be disposed above the insulating layer opening 241. The second electrode 320 extends from at least one light emitter 200 to an adjacent light emitter 200, and the cover layer 500 is disposed between the plurality of light emitters 200, so the second electrode 320 may pass over the upper surface of the cover layer 500. When the second electrode 320 passes between the plurality of light emitters 200, since the cover layer 500 may support the second electrode 320, the second electrode 320 may be kept away from the substrate 100 to avoid contact with the first electrode 310 and prevent a short circuit, and a current path of the second electrode 320 may be shortened to increase a current movement speed.

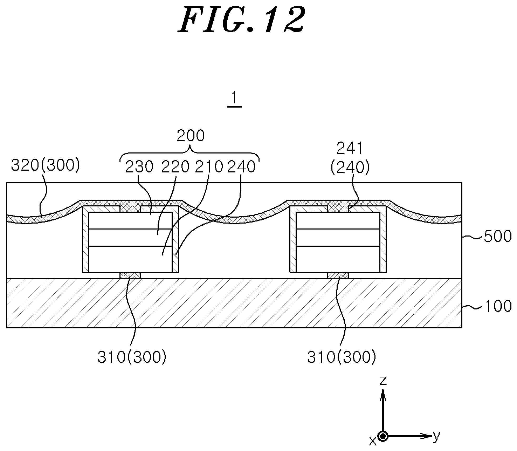

In addition, referring back to FIG. 12, the plurality of second electrodes 320 may be disposed to have a curved surface so as to be bent by the cover layer 500. For example, the second electrode 320 may be supported by the cover layer 500 while being bent downward so as to be positioned below upper end portions of the plurality of light emitters among the plurality of light emitters. The stress applied to the second electrode 320 by the curved surface may be relieved, and the second electrode 320 may be prevented from being broken.

Hereinafter, the operation and effect of the light emitting device 1 according to the first embodiment of the present disclosure will be described.

Each of the plurality of light emitters 200 of the light emitting device 1 according to the first embodiment of the present disclosure may be electrically connected to the first electrode 310 and the second electrode 320 so that the plurality of light emitters 200 may be driven individually. The light emitted from the plurality of light emitters 200 may be emitted to the outside through the cover layer 500.

The plurality of light emitters 200 of the light emitting device 1 may be driven individually.

In addition, the defect factors of the light emitter 200 of the light emitting device 1 may be minimized and the light efficiency may be improved.

In addition, light may be prevented from being absorbed inside the second conductive semiconductor layer 230 of the light emitting device 1, thereby improving the light extraction efficiency.

In addition, the light emitter 200 may be protected from the external environment by the insulating layer 240 of the light emitting device 1.

In addition, light may be diffused by the unevenness 250, so the light extraction efficiency of the light emitter 200 may be increased.

In addition, since the plurality of light emitters 200, the plurality of first electrodes 310, and the plurality of second electrodes 320 may be protected by the cover layer 500, the reliability of the light emitting device 1 may be improved.

In addition, the plurality of light emitters 200, the plurality of first electrodes 310, and the plurality of second electrodes 320 may be prevented from being detached or peeled off from the light emitting device 1 by the cover layer 500.

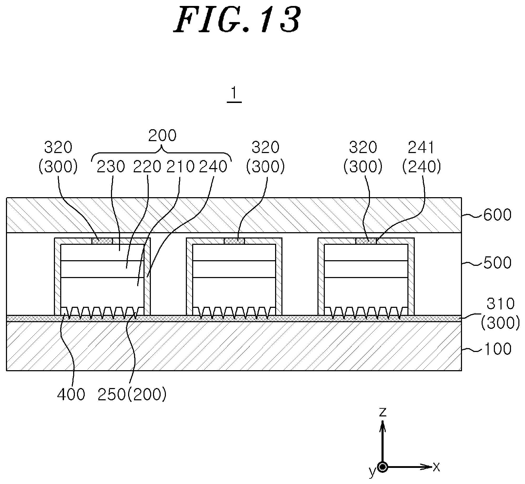

Hereinafter, a light emitting device 1 according to a second embodiment of the present disclosure will be described with reference to FIG. 13. In describing the second embodiment, since there is a difference in that an outer layer 600 is further included, this difference will be mainly described.

The outer layer 600 of the light emitting device 1 according to the second embodiment of the present disclosure may be disposed on the cover layer 500. The outer layer 600 may be formed of a different material or a material having different properties from the cover layer 500. An interface may be formed between the outer layer 600 and the cover layer 500. The interface between the outer layer 600 and the cover layer 500 may include an irregular pattern region, but is not limited thereto. In other words, the outer layer 600 and the cover layer 500 may be formed of a single molding layer. In addition, the outer layer 600 and the cover layer 500 may be formed of the same material and may be formed without an interface boundary. An upper surface of the outer layer 600 may be formed flat, but is not limited thereto, and at least one region of the upper surface of the outer layer 600 may include a curved region or an inclined region. The outer layer 600 may diffuse light. This outer layer 600 may be called a diffusion layer.

Hereinafter, the operation and effect of the light emitting device 1 according to the second embodiment of the present disclosure will be described.

The light emitted from the plurality of light emitters 200 may sequentially transmit through the cover layer 500 and the outer layer 600 and be emitted to the outside.

Since the light may be diffused by the outer layer 600 of the light emitter 200, the light extraction efficiency may be increased.

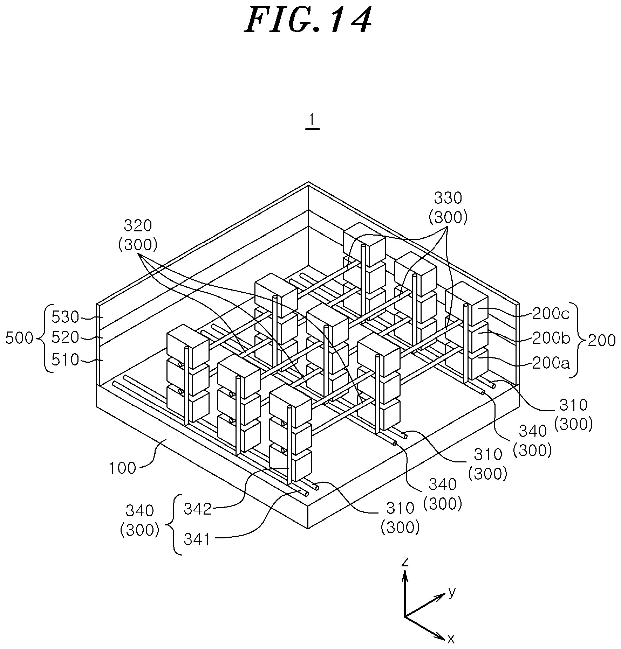

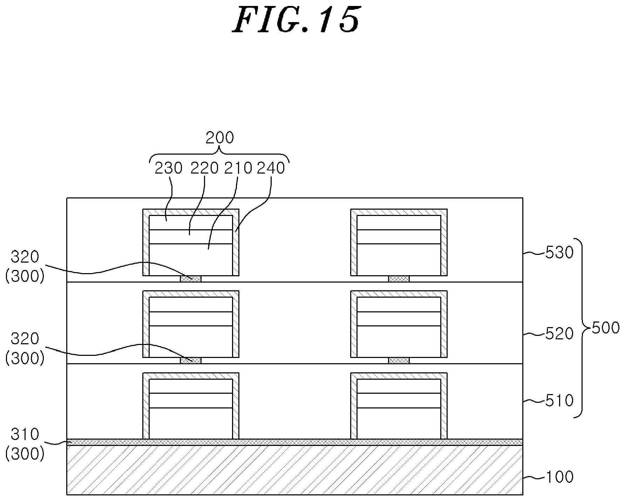

Hereinafter, a light emitting device 1 according to a third embodiment of the present disclosure will be described with reference to FIGS. 14 and 15.

In describing the third embodiment, since there is a difference in that the plurality of light emitters 200 may include a plurality of first light emitters 200a, a plurality of second light emitters 200b, and a plurality of third light emitters 200c, and the cover layer 500 may include a first cover layer 510, a second cover layer 520, and a third cover layer 530, this difference will be mainly described.

The plurality of first light emitters 130, the plurality of second light emitters 200b, and the plurality of third light emitters 200c may be stacked upward.

The plurality of first light emitters 200a may be disposed on the substrate 100. The plurality of first light emitters 200a may be arranged in the other direction while being arranged in one direction. Each of the plurality of light emitters 200 may be disposed in N rows and M columns to emit light. The plurality of first light emitters 200a may emit light of the same color, but is not limited thereto. In other words, some of the plurality of first light emitters 200a may emit light of a different color than others of the plurality of first light emitters 200a. In addition, the plurality of first light emitters 200a may emit light of a different color than the plurality of second light emitters 200b and the plurality of third light emitters 200c. For example, the plurality of first light emitters 200a may emit red light.

The plurality of second light emitters 200b may be disposed above the plurality of first light emitters 200a. In addition, the plurality of second light emitters 200b may be arranged in the other direction while being arranged in one direction. For example, each of the plurality of second light emitters 200b may be disposed in N rows and M columns to emit light. In addition, the plurality of second light emitters 200b may be arranged so as to overlap the plurality of first light emitters 200a when viewed from above. In other words, the second light emitters 200b may be disposed so that at least some thereof are positioned in an upper region of each of the plurality of first light emitters 200a.

The plurality of second light emitters 200b may emit light of the same color, but is not limited thereto. In other words, some of the plurality of second light emitters 200b may emit light of a different color than some of the plurality of other second light emitters 200b. For example, the plurality of second light emitters 200b may emit green light.

The plurality of third light emitters 200c may be disposed above the plurality of second light emitters 200b. In addition, the plurality of third light emitters 200c may be arranged in the other direction while being arranged in one direction. For example, each of the plurality of third light emitters 200c may be disposed in N rows and M columns to emit light. In addition, the plurality of third light emitters 200c may be arranged so as to overlap the plurality of first light emitters 200a and the plurality of second light emitters 200b when viewed from above. In other words, the third light emitters 200c may be disposed so that at least some thereof are positioned in a region directly above each of the plurality of second light emitters 200b.

The plurality of third light emitters 200c may emit light of the same color, but is not limited thereto. In other words, some of the plurality of third light emitters 200c may emit light of a different color than some of the plurality of other third light emitters 200c. For example, the plurality of third light emitters 200c may emit blue light.

Meanwhile, the first light emitter 200a, the second light emitter 200b, and the third light emitter 200c, which are at least partially overlapped when viewed from the upper side, may be configured as one light emitting module. In other words, the light emitting device 1 may include a plurality of light emitting modules.

In order for the plurality of first light emitters 200a, the plurality of second light emitters 200b, and the plurality of third light emitters 200c to operate, the plurality of electrodes 300 may include the plurality of first electrodes 310, the plurality of second electrodes 320, a plurality of third electrodes 330, and a plurality of common electrodes 340. Meanwhile, the first electrode 310 and the second electrode 320 in the second embodiment may be disposed differently from the first electrode 310 and the second electrode 320 in the first embodiment described above.

The plurality of first electrodes 310 may be disposed between the plurality of first light emitters 200a and the substrate 100 and connected to the plurality of first light emitters 200a. In other words, the plurality of first electrodes 310 may be connected to the second conductive semiconductor layer 230 of the plurality of first light emitters 200a. The plurality of first electrodes 310 may be disposed to extend in one direction and be spaced apart from each other in the other direction, but is not limited thereto. In other words, the plurality of first electrodes 310 may be disposed to extend in the other direction and be spaced apart from each other in the one direction. Hereinafter, a description will be given mainly of the plurality of first electrodes 310 disposed to extend in one direction and be spaced apart from each other in the other direction.

Each of the plurality of first electrodes 310 may be connected to some of the first light emitters 200a arranged in one direction among the plurality of first light emitters 200a, but is not limited thereto. In other words, each of the plurality of first electrodes 310 may extend in the other direction and be spaced apart from each other in the one direction to be connected to some of the first light emitters 200a arranged in the other direction among the plurality of first light emitters 200a. When viewed from above, at least some of the plurality of first electrodes 310, the plurality of second electrodes 320, and the plurality of third electrodes 330 may be disposed to intersect each other. For example, any one of the plurality of first electrodes 310 may intersect at least one of the plurality of second electrodes 320 and at least one of the plurality of third electrodes 330 when viewed from above. Therefore, when viewed from above, the area of the electrode overlapping the first light emitter 200a may be minimized, thereby minimizing the absorption of light emitted from the first light emitter 200a by the electrode.

Any one of the plurality of first electrodes 310 may be connected to some of the plurality of first light emitters 200a. Another one of the plurality of first electrodes 310 may be connected to some of the plurality of other first light emitters 200a. Another one of the plurality of first electrodes 310 may be connected to some other of the plurality of first light emitters 200a. For example, each of the plurality of first electrodes 310 may be connected to two or more first light emitters 200a.

Meanwhile, although it has been described that the plurality of first electrodes 310 are positioned between the substrate 100 and the plurality of first light emitters 200a, the present disclosure is not limited thereto. In other words, the plurality of first electrodes 310 may be positioned between the plurality of first light emitters 200a and the plurality of second light emitters 200b and connected to the plurality of first light emitters 200a.

The plurality of second electrodes 320 may be connected to the plurality of second light emitters 200b. In other words, the plurality of second electrodes 320 may be connected to the second conductive semiconductor layer 230 of the plurality of second light emitters 200b. The plurality of second electrodes 320 may be disposed between the plurality of first light emitters 200a and the plurality of second light emitters 200b. In other words, the plurality of second electrodes 320 may be disposed above the plurality of first light emitters 200a and below the plurality of second light emitters 200b. The plurality of second electrodes 320 may be disposed to extend in the other direction and be spaced apart from each other in one direction, but is not limited thereto. In other words, the plurality of second electrodes 320 may be disposed to extend in one direction and be spaced apart from each other in the other direction. Hereinafter, a description will be given mainly of the plurality of second electrodes 320 disposed to extend in the other direction and be spaced apart from each other in one direction.

Each of the plurality of second electrodes 320 may be connected to some of the second light emitters 200b arranged in the other direction among the plurality of second light emitters 200b. In other words, any one of the plurality of second electrodes 320 may be connected to some of the second light emitters 200b arranged in the other direction among the plurality of second light emitters 200b. Another one of the plurality of second electrodes 320 may be connected to some of the plurality of other second light emitters 200b arranged in the other direction. Another one of the plurality of second electrodes 320 may be connected to some other of the second light emitters 200b arranged in the other direction among the plurality of second light emitters 200b. For example, each of the plurality of second electrodes 320 may be connected to two or more second light emitters 200b.

Meanwhile, although it has been described that the plurality of second electrodes 320 are positioned between the plurality of first light emitters 200a and the plurality of second light emitters 200b, it is not limited thereto. In other words, the plurality of second electrodes 320 may be disposed between the plurality of second light emitters 200b and the plurality of third light emitters 200c and connected to the plurality of second light emitters 200b.

The plurality of third electrodes 330 may be connected to the plurality of third light emitters 200c. In other words, the plurality of third electrodes 330 may be connected to the second conductive semiconductor layer 230 of the plurality of third light emitters 200c. The plurality of third electrodes 330 may be positioned between the plurality of second light emitters 200b and the plurality of third light emitters 200c. In other words, the plurality of third electrodes 330 may be disposed above the plurality of second light emitters 200b and below the plurality of third light emitters 200c. The plurality of third electrodes 330 may be disposed to extend in the other direction and be spaced apart from each other in one direction, but is not limited thereto. In other words, the plurality of third electrodes 330 may be disposed to extend in one direction and be spaced apart from each other in the other direction. Hereinafter, a description will be given mainly of the plurality of third electrodes 330 disposed to extend in the other direction and be spaced apart from each other in one direction.

Each of the plurality of third electrodes 330 may be connected to some of the third light emitters 200c arranged in the other direction among the plurality of third light emitters 200c. In other words, any one of the plurality of third electrodes 330 may be connected to some of the third light emitters 200c arranged in the other direction among the plurality of third light emitters 200c. Another one of the plurality of third electrodes 330 may be connected to some of the other third light emitters 200c arranged in the other direction among the plurality of third light emitters 200c. Another one of the plurality of third electrodes 330 may be connected to some other of the third light emitters 200c arranged in the other direction among the plurality of third light emitters 200c. For example, each of the plurality of third electrodes 330 may be connected to two or more third light emitters 200c.

Meanwhile, although the plurality of third electrodes 330 have been described as being positioned between the plurality of second light emitters 200b and the plurality of third light emitters 200c, it is not limited thereto. In other words, the plurality of third electrodes 330 may be disposed above the plurality of third light emitters 200c. In addition, the heights of at least some of the first electrode 310, the second electrode 320, and the third electrode 330 may be formed differently from each other.

The plurality of common electrodes 340 may be connected to the plurality of first light emitters 200a, the plurality of second light emitters 200b, and the plurality of third light emitters 200c. In other words, the plurality of common electrodes 340 may be connected to the first conductive semiconductor layers 210 of each of the plurality of first light emitters 200a, the plurality of second light emitters 200b, and the plurality of third light emitters 200c. The plurality of common electrodes 340 may be disposed to be spaced apart from each other in the other direction. In addition, each of the plurality of common electrodes 340 may be connected to some of the first light emitters 200a arranged in one direction, some of the second light emitters 200b arranged in one direction, and some of the third light emitters 200c arranged in one direction. Each of the plurality of common electrodes 340 may include a first common electrode 341 and a plurality of second common electrodes 342.

The first common electrode 341 may be disposed on the substrate 100 and extend in one direction. In addition, the first common electrode 341 may be connected to the plurality of second common electrodes 342.

The plurality of second common electrodes 342 may be spaced apart from each other in one direction and extend upward from the first common electrode 341. Each of the plurality of second common electrodes 342 may be connected to any one of the plurality of first light emitters 200a, any one of the plurality of second light emitters 200b, and any one of the plurality of third light emitters 200c. Meanwhile, the second common electrode 342 may penetrate through the first cover layer 510, the second cover layer 520, and the third cover layer 530 so as to be connected to the first light emitter 200a, the second light emitter 200b, and the third light emitter 200c. The second common electrode 342 may extend in a thickness direction along side surfaces of the first light emitter 200a, the second light emitter 200b, and the third light emitter 200c. The second common electrode 342 may extend in a direction perpendicular to the plane of the substrate 100 to form a short path of the second common electrode 342, thereby reducing electrical resistance.

The first cover layer 510 may be disposed on the substrate 100 to cover the plurality of first light emitters 200a and the plurality of first electrodes 310. In other words, the first cover layer 510 may cover at least a portion of the side and upper surfaces of the plurality of first light emitters 200a. In addition, at least a portion of the first cover layer 510 may be disposed between the plurality of second electrodes 320 and the plurality of first light emitters 200a so that the plurality of second electrodes 320 are spaced apart from the plurality of first light emitters 200a. In addition, the first cover layer 510 may support the plurality of second electrodes 320 and the plurality of second light emitters 200b. Therefore, it is possible to prevent the plurality of second electrodes 320 from contacting the substrate 100 in the region between the first light emitters 200a.

The second cover layer 520 may be disposed above the first cover layer 510 to cover the plurality of second light emitters 200b and the plurality of second electrodes 320. In other words, the second cover layer 520 may cover at least a portion of the side and upper surfaces of the plurality of second light emitters 200b. In addition, at least a portion of the second cover layer 520 may be disposed between the plurality of third electrodes 330 and the plurality of second light emitters 200b so that the plurality of third electrodes 330 are spaced apart from the plurality of second light emitters 200b. The second cover layer 520 may support the plurality of third electrodes 330 and the plurality of third light emitters 200c. Therefore, the third electrodes 330 may be prevented from contacting the substrate 100 in the region between the second light emitters 200b.

The third cover layer 530 may be disposed above the second cover layer 520 to cover the plurality of third light emitters 200c and the plurality of third electrodes 330. In other words, the third cover layer 530 may cover at least a portion of the side and upper surfaces of the plurality of third light emitters 200c.

The first cover layer 510, the second cover layer 520, and the third cover layer 530 may be formed of the same material or different materials. In addition, the heights of at least some of the first cover layer 510, the second cover layer 520, and the third cover layer 530 may be formed differently from each other. For example, the heights of the first cover layer 510 and the second cover layer 520 may be formed differently from each other.

Hereinafter, the operation and effect of the light emitting device 1 according to the third embodiment of the present disclosure will be described.

At least some of the light emitted from the plurality of first light emitters 200a, the plurality of second light emitters 200b, and the plurality of third light emitters 200c may be emitted to the outside by transmitting through at least one of the first cover layer 510, the second cover layer 520, and the third cover layer 530.

The plurality of first light emitters 200a, the plurality of second light emitters 200b, and the plurality of third light emitters 200c may be individually driven.

The plurality of first electrodes 310, the plurality of second electrodes 320, and the plurality of third electrodes 330 may be disposed to be spaced apart from each other vertically or horizontally, so the circuit arrangement may be simplified and the interference between the electrodes may be prevented.

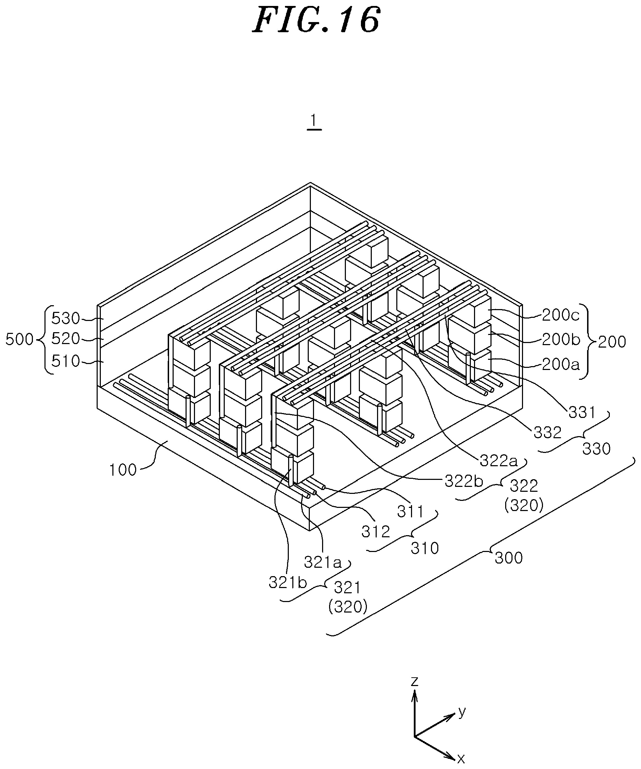

Hereinafter, a light emitting device 1 according to a fourth embodiment of the present disclosure will be described with reference to FIG. 16. In describing the fourth embodiment, since there is a difference in that the disposition of the first electrode 310, the second electrode 320, and the third electrode 330 may be formed differently from the above-described embodiment, this difference will be mainly described.

The plurality of first electrodes 310 may be disposed on the substrate 100 and spaced apart from each other in the other direction. Any one of the plurality of first electrodes 310 may be connected to some of the plurality of first light emitters 200a. Another one of the plurality of first electrodes 310 may be connected to some of the plurality of other first light emitters 200a. Another one of the plurality of first electrodes 310 may be connected to some other of the plurality of first light emitters 200a. Each of the plurality of first electrodes 310 may include a first sub-electrode 311 and a second sub-electrode 312.

The first sub-electrode 311 may have a different polarity from the second sub-electrode 312. The first sub-electrode 311 may extend in one direction from the substrate 100 and be connected to some of the plurality of first light emitters 200a. The first sub-electrode 311 and the second sub-electrode 312 may be disposed to face a lower surface of the first light emitter 200a. The first sub-electrode 311 may be electrically connected to any one of the first conductive semiconductor layer 210 and the second conductive semiconductor layer 230 of the first light emitter 200a.

The second sub-electrode 312 may be disposed in one direction on the substrate 100 and connected to some of the plurality of first light emitters 200a. The second sub-electrode 312 may be disposed to be spaced apart from the first sub-electrode 311 in the other direction. In addition, the second sub-electrode 312 may be electrically connected to the other of the first conductive semiconductor layer 210 and the second conductive semiconductor layer 230 of the first light emitter 200a.

The plurality of first light emitters 200a connected to the first electrodes 310 may be flip chips in which a mesa is formed. In other words, the plurality of first light emitters 200a may be etched to expose one surface of the first conductive semiconductor layer 210, and thus, may include at least one step and mesa region. In addition, the first light emitter 200a may be disposed so that the second conductive semiconductor layer 230 is closer to the substrate 100 than the first conductive semiconductor layer 210. Accordingly, the second conductive semiconductor layer 230 of the first light emitter 200a facing the substrate 100 may have a narrower area than the first conductive semiconductor layer 210.

The plurality of second electrodes 320 may be connected to the plurality of second light emitters 200b. Any one of the plurality of second electrodes 320 may be connected to some of the plurality of second light emitters 200b. Another one of the plurality of second electrodes 320 may be connected to some of the plurality of other second light emitters 200b. Another one of the plurality of second electrodes 320 may be connected to some other of the plurality of second light emitters 200b. Each of the plurality of second electrodes 320 may include a third sub-electrode 321 and a fourth sub-electrode 322.

The third sub-electrode 321 may be disposed on the substrate 100 and connected to the plurality of second light emitters 200b. The third sub-electrode 321 may include a 3-1st sub-electrode 321a and a plurality of 3-2nd sub-electrodes 321b.

The 3-1st sub-electrode 321a may extend in one direction from the substrate 100. The 3-1st sub-electrode 321a may support a plurality of 3-2nd sub-electrodes 321b.

The plurality of 3-2nd sub-electrodes 321b may be spaced apart from each other in one direction and extend upward from the 3-1st sub-electrode 321a. Each of the plurality of 3-2nd sub-electrodes 321b may be connected to different second light emitters 200b. The 3-2nd sub-electrode 321b may be connected to any one of the first conductive semiconductor layer 210 and the second conductive semiconductor layer 230 of the second light emitters 200b. The plurality of 3-2nd sub-electrodes 321b may pass through an outer side of the mesa of the first light emitter 200a and be connected to the second light emitter 200b. In other words, the plurality of 3-2nd sub-electrodes 321b may extend from an outer side of one light emitter. Since the plurality of 3-2nd sub-electrodes 321b extend from the outer side of the light emitter, the number of light emitters through which the 3-2nd sub-electrodes 321b pass may be reduced, so the number of electrodes passing through the step and inclined surface of the light emitters may be minimized and the chip efficiency may be improved. As a result, a high current density may be supplied to the light emitting device 1, thereby improving the reliability of the plurality of light emitters 200.

The fourth sub-electrode 322 may be spaced apart from the substrate 100 and connected to the plurality of second light emitters 200b. The fourth sub-electrode 322 may include a 4-1st sub-electrode 322a and a plurality of 4-2nd sub-electrodes 322b.

The 4-1st sub-electrode 322a may be disposed above the plurality of third light emitters 200c and may extend in the other direction. The 4-1st sub-electrode 322a may support the plurality of 4-2nd sub-electrodes 322b.

The plurality of 4-2nd sub-electrodes 322b may be spaced apart from each other in the other direction and may extend downward from the 4-1st sub-electrode 322a. Each of the plurality of 4-2nd sub-electrodes 322b may be connected to different second light emitters 200b. The 4-2nd sub-electrode 322b may be connected to the other of the first conductive semiconductor layer 210 and the second conductive semiconductor layer 230 of the second light emitter 200b. Since the plurality of 4-2nd sub-electrodes 322b and the plurality of 3-2nd sub-electrodes 321b may extend in opposite directions to each other, the electrodes may be prevented from being concentrated and complicated and the efficiency of the disposition of the electrodes may be increased. In addition, the plurality of 4-2nd sub-electrodes 322b may extend from the outside of the mesa of the third light emitter 200c. In other words, since the plurality of 4-2nd sub-electrodes 322b extend from the outer side of the light emitter, the number of light emitters through which the 4-2nd sub-electrodes 321b pass may be reduced, so the number of electrodes passing through the step and inclined surface of the light emitter may be minimized and the chip efficiency may be improved. As a result, the high current density may be supplied to the light emitting device 1, thereby improving the reliability of the plurality of light emitters 200.

The plurality of second light emitters 200b connected to the second electrode 320 may be etched so that the first conductive semiconductor layer 210 is exposed, and may include at least one step and mesa region. The second light emitter 200b may be disposed so that the second conductive semiconductor layer 230 is closer to the substrate than the first conductive semiconductor layer 210, so the area of the second conductive semiconductor layer 230 of the second light emitter 200b may be smaller than that of the upper surface of the first light emitter 200a. Alternatively, in contrast, the first conductive semiconductor layer 210 may be disposed closer to the substrate 100 than the second conductive semiconductor layer 230 of the second light emitter 200b, so an area of one surface of the first conductive semiconductor layer 210 of the second light emitter 200b may be larger than that of the upper surface of the first light emitter 200a. In addition, the height of the second light emitter 200b may be formed greater than the heights of the first light emitter 200a and the third light emitter 200c. Even if the third light emitter 200c and the plurality of electrodes are disposed on the second light emitter 200b, the second light emitter 200b may be prevented from being bent and the plurality of electrodes may be prevented from being short-circuited. The height of the second light emitter 200b may be 100 nm or more, exceeding the height of the first light emitter 200a.

Meanwhile, a bonding layer may be disposed between the first light emitter 200a and the second light emitter 200b. The bonding layer may be disposed to extend between the plurality of first light emitters 200a. In another form, a first filling material may be disposed between the plurality of first light emitters 200a, a second filling material may be disposed between the plurality of second light emitters 200b, and the bonding layer may be disposed between the first filling material and the second filling material to extend between the first light emitter 200a and the second light emitter 200b.

The plurality of third electrodes 330 may be connected to the plurality of third light emitters 200c. Any one of the plurality of third electrodes 330 may be connected to some of the plurality of third light emitters 200c. Another one of the plurality of second electrodes 320 may be connected to some of the plurality of other third light emitters 200c. Another one of the plurality of third electrodes 330 may be connected to some other of the plurality of third light emitters 200c. The plurality of third electrodes 330 may include a fifth sub-electrode 331 and a sixth sub-electrode 332.

The fifth sub-electrode 331 may have a different polarity from the sixth sub-electrode 332. The fifth sub-electrode 331 may extend in the other direction from the upper side of the plurality of third light emitters 200c and be connected to some of the plurality of third light emitters 200c. The fifth sub-electrode 331 and the sixth sub-electrode 332 may be disposed to face the upper surface of the third light emitter 200c. The fifth sub-electrode 331 may be electrically connected to any one of the first conductive semiconductor layer 210 and the second conductive semiconductor layer 230 of the third light emitter 200c.

The sixth sub-electrode 332 may extend in the other direction from the upper side of the plurality of third light emitters 200c and be connected to some of the plurality of third light emitters 200c. The sixth sub-electrode 332 may be disposed to be spaced apart from the fifth sub-electrode 331 in the other direction. In addition, the sixth sub-electrode 332 may be electrically connected to another one of the first conductive semiconductor layer 210 and the second conductive semiconductor layer 230 of the third light emitter 200c.

The plurality of third light emitters 200c connected to the third electrode 330 may be etched to expose one surface of the first conductive semiconductor layer 210, and may include at least one step and mesa region. The third light emitters 200c may be disposed so that the second conductive semiconductor layer 230 is closer to the substrate than the first conductive semiconductor layer 210. The area of one surface of the second conductive semiconductor layer 230 of the third light emitter 200c may be smaller than that of the upper surface of the second light emitter 200b facing the third light emitter 200c. Alternatively, in contrast, the first conductive semiconductor layer 210 may be disposed closer to the substrate 100 than the second conductive semiconductor layer 230 of the third light emitter 200c so that the area of the first conductive semiconductor layer 210 of the third light emitter 200c may be larger than that of the upper surface of the second light emitter 200b facing the third light emitter 200c.

At least one of the first light emitter 200a, the second light emitter 200b, and the third light emitter 200c may include the mesa region, and may be disposed so that the mesa region may be disposed to be formed in the same direction with respect to one surface of the first conductive semiconductor layer 210. Alternatively, at least one of the first light emitter 200a, the second light emitter 200b, and the third light emitter 200c may be disposed so that the mesa region may be disposed to be formed in different directions.

Hereinafter, the operation and effect of the light emitting device 1 according to the fourth embodiment of the present disclosure will be described.

Since the number of light emitters through which the second electrode 320 of the light emitting device 1 according to the fourth embodiment of the present disclosure passes may be reduced, the number of electrodes passing through the step and inclined surface of the light emitter may be minimized, and the chip efficiency may be improved. As a result, the high current density may be supplied to the light emitting device 1, thereby improving the reliability of the plurality of light emitters 200.

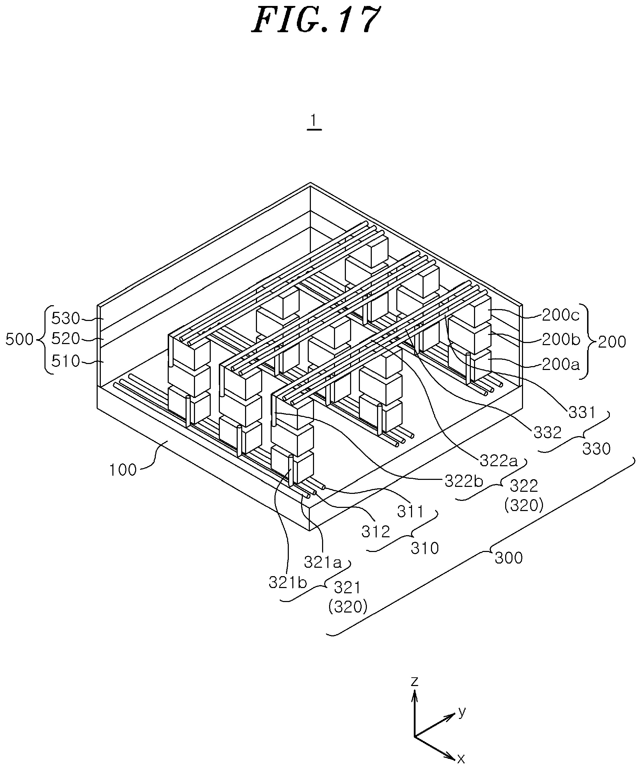

Hereinafter, a light emitting device 1 according to a fifth embodiment of the present disclosure will be described with reference to FIG. 17. In describing the fifth embodiment, since there is a difference in the disposition of the second electrode 320, this difference will be mainly described.

According to the fifth embodiment of the present disclosure, at least one of the first light emitter 200a, the second light emitter 200b, and the third light emitter 200c of the light emitting device 1 may not include the mesa region. In other words, the plurality of second light emitters 200b may be formed in a vertical structure in which a position where the first conductive semiconductor layer 210 and the second electrode 320 are connected and a position where the second conductive semiconductor layer 230 and the second electrode 320 are connected are positioned in opposite directions to each other. The difference in the upper area of the first conductive semiconductor layer 210 and the second conductive semiconductor layer 230 of the second light emitter 200b may be 0% or more and 10% or less. The outer side surfaces of the first conductive semiconductor layer 210 and the second conductive semiconductor layer 230 of the second light emitter 200b may be linearly connected.

The plurality of 3-2nd sub-electrodes 321b of the second electrode 320 may be disposed below the side surface of the mesa of the second light emitter 200b and connected to the second light emitter 200b. Since the second electrode 320 may extend from the side surface of the first light emitter 200a, the number of steps through which the electrodes pass may be reduced.

The plurality of 4-2nd sub-electrodes 322b of the second electrode 320 may be disposed above the side surface of the mesa of the second light emitter 200b and connected to the second light emitter 200b. Since the plurality of 4-2nd sub-electrodes 322b may extend from the side surface of the third light emitter 200c, the number of steps through which the electrodes pass may be reduced.

Hereinafter, the operation and effect of the light emitting device 1 according to the fifth embodiment of the present disclosure will be described.

Since the plurality of 3-2nd sub-electrodes 321b may be disposed below the side surface of the mesa of the second light emitter 200b, the number of steps through which the electrodes pass may be reduced.

Since the plurality of 4-2nd sub-electrodes 322b may be disposed above the side surface of the mesa of the second light emitter 200b, the number of steps through which the electrodes pass may be reduced.

The examples of the present disclosure have been described above as specific embodiments, but these are only examples, and the present disclosure is not limited thereto, and should be construed as having the widest scope according to the technical spirit disclosed in the present specification. A person skilled in the art may combine/substitute the disclosed embodiments to implement a pattern of a shape that is not disclosed, but it also does not depart from the scope of the present disclosure. In addition, those skilled in the art can easily change or modify the disclosed embodiments based on the present specification, and it is clear that such changes or modifications also belong to the scope of the present disclosure.

## Claims

1. A light emitting device, comprising:
a substrate;
a plurality of light emitters disposed on an upper surface of the substrate to emit light;
a first electrode disposed between the substrate and the plurality of light emitters and electrically connected to the plurality of light emitters; and
a second electrode spaced apart from the substrate and electrically connected to the plurality of light emitters,
wherein the first electrode and the second electrode are spaced apart from each other in an up and down direction by at least one of the plurality of light emitters, and extend while intersecting in the at least one light emitter when viewed from above.

2. The light emitting device of claim 1, wherein an intersection where the first electrode and the second electrode intersect is formed in a rectangular or a rhombus shape.

3. The light emitting device of claim 1, wherein the first electrode extends in one direction and is connected to the plurality of light emitters,
the second electrode extends in the other direction different from the one direction and is connected to the plurality of light emitters,
a length of the first electrode perpendicular to the one direction is 70% or less of a length of the one light emitter perpendicular to the one direction, and
a length of the second electrode in a direction perpendicular to the other direction is 70% or less of a length of the at least one light emitter in the direction perpendicular to the other direction.

4. The light emitting device of claim 1, wherein an area of an upper surface of the at least one light emitter is 60% or more of an area of the first electrode projected toward the at least one light emitter.

5. The light emitting device of claim 1, wherein the first electrode and the second electrode are formed in plural, and
wherein each of the plurality of light emitters includes:
a first conductive semiconductor layer connected to the first electrode;
an active layer stacked on the first conductive semiconductor layer; and
a second conductive semiconductor layer connected to the second electrode, and
wherein the active layer is disposed above a center of the light emitter.

6. The light emitting device of claim 5, wherein each of the plurality of light emitters further includes an insulating layer that covers the first conductive semiconductor layer, the active layer, and the second conductive semiconductor layer,
wherein the insulating layer is formed with an insulating layer opening, and
wherein the plurality of second electrodes are electrically connected to the first conductive semiconductor layer, the active layer, or the second conductive semiconductor layer through the insulating layer opening.

7. The light emitting device of claim 6, wherein, when viewed from above, an edge of the insulating layer opening is disposed inward from an edge of the second electrode.

8. The light emitting device of claim 6, wherein the second electrode is electrically connected to one of the plurality of light emitters and a light emitter adjacent to the one of the plurality of light emitters, and
a virtual line connecting a center of the insulating layer opening of the one of the plurality of light emitters and a center of the insulating layer opening of the adjacent light emitter is disposed to be misaligned from a side surface of the second electrode.

9. The light emitting device of claim 1, wherein unevenness is formed on a lower surface of the plurality of light emitters.

10. The light emitting device of claim 1, wherein the second electrode is bent downward so as to be disposed below an upper end portion of the plurality of light emitters between the plurality of light emitters.

11. A light emitting device, comprising:
a substrate;
a plurality of first light emitters disposed on the substrate;
a plurality of second light emitters disposed above the plurality of first light emitters;
a plurality of third light emitters disposed above the plurality of second light emitters;
a plurality of first electrodes disposed between the plurality of first light emitters and the substrate and electrically connected to the plurality of light emitters;
a plurality of second electrodes disposed between the plurality of first light emitters and the plurality of second light emitters and electrically connected to the plurality of second light emitters;
a plurality of third electrodes disposed between the plurality of second light emitters and the plurality of third light emitters and electrically connected to the plurality of light emitters; and
a plurality of common electrodes electrically connected to the plurality of first light emitters, the plurality of second light emitters, and the plurality of third light emitters.

12. The light emitting device of claim 11, wherein the plurality of first electrodes are disposed to intersect the plurality of second electrodes or the plurality of third electrodes when viewed from above.

13. The light emitting device of claim 11, wherein the plurality of first electrodes are disposed to extend in one direction and be spaced apart from each other in the other direction different from the one direction, and are connected to some of the plurality of first light emitters,
the plurality of second electrodes are spaced apart from each other in the one direction and extend in the other direction, and are connected to some of the plurality of second light emitters, and
the plurality of third electrodes are disposed to extend in the other direction and be spaced apart from each other in the one direction.

14. The light emitting device of claim 13, wherein the plurality of first electrodes are disposed to extend in the one direction and be spaced apart from each other in the other direction or extend in the other direction and be spaced apart from each other in the one direction, and are connected to some of the plurality of first light emitters.

15. The light emitting device of claim 13, wherein each of the plurality of common electrodes includes:
a first common electrode disposed on the substrate and extending in the one direction; and
a plurality of second common electrodes extending upward from the first common electrode and connected to one of the plurality of first light emitters, one of the plurality of second light emitters, and one of the plurality of third light emitters.

16. The light emitting device of claim 13, wherein some of the plurality of first light emitters are arranged in the one direction and connected to one of the plurality of first electrodes,
some of the plurality of second light emitters are arranged in the one direction and connected to different second electrodes among the plurality of second electrodes, and
some of the plurality of third light emitters are arranged in the one direction and connected to different third electrodes among the plurality of third electrodes.

17. The light emitting device of claim 16, wherein another portion of the plurality of first light emitters are arranged in the other direction and connected to different first electrodes among the plurality of first electrodes,
another portion of the plurality of other second light emitters are arranged in the other direction and connected to one of the plurality of second electrodes, and
some of the plurality of other third light emitters are arranged in the other direction and connected to one of the plurality of third electrodes.

18. The light emitting device of claim 11, further comprising:
a first cover layer covering the plurality of first light emitters and the plurality of first electrodes;
a second cover layer disposed above the first cover layer and covering the plurality of second light emitters and the plurality of second electrodes; and
a third cover layer disposed above the second cover layer and covering the plurality of third light emitters and the plurality of third electrodes,
wherein a portion of the first cover layer is disposed between the plurality of first light emitters and the plurality of second electrodes, and
a portion of the second cover layer is disposed between the plurality of second light emitters and the plurality of third electrodes.

19. A light emitting device, comprising:
a substrate;
a plurality of light emitters disposed on an upper surface of the substrate to emit light;
a plurality of first electrodes disposed between the substrate and the plurality of light emitters, extending in one direction, spaced apart from each other in the other direction different from the one direction, and electrically connected to the plurality of light emitters;
a plurality of second electrodes spaced apart from the substrate, extending in the other direction, spaced apart from each other in the one direction and electrically connected to the plurality of light emitters; and
a cover layer covering the plurality of light emitters, the plurality of first electrodes, and the plurality of second electrodes.

20. The light emitting device of claim 19, further comprising:
an outer layer stacked on the cover layer.
